# EUROPÄISCHE PATENTSCHRIFT

(11) **EP 3 443 659 B1**
(45) Veröffentlichungstag und Bekanntmachung des Hinweises auf die Patenterteilung: **13.05.2020**
(21) Anmeldenummer: 17719815.7
(22) Anmeldetag: 07.04.2017
(51) Int. Cl.: H02N 13/00

(54) **ELEKTROADHÄSIONSGREIFER MIT FRAKTALEN ELEKTRODEN**
ELECTRO-ADHESION GRIPPER COMPRISING FRACTAL ELECTRODES
PINCE À ÉLECTRO-ADHÉSION À ÉLECTRODES FRACTALES

(30) Priorität: 13.04.2016 DE 102016206193
(43) Veröffentlichungstag der Anmeldung: 20.02.2019
(73) Patentinhaber: Trumpf GmbH + Co. KG, 71254 Ditzingen (DE)
(72) Erfinder: HEINZ, Alexander, 71665 Vaihingen an der Enz (DE)
(74) Vertreter: Kohler Schmid Möbus Patentanwälte
(86) Internationale Anmeldenummer: PCT/EP2017/058344
(87) Internationale Veröffentlichungsnummer: WO 2017/178355

(56) Entgegenhaltungen:
- DE-B3-102014 215 333
- DONALD RUFFATTO ET AL: "Optimization and experimental validation of electrostatic adhesive geometry", AEROSPACE CONFERENCE, 2013 IEEE, IEEE, 2. März 2013 (2013-03-02), Seiten 1-8, XP032397079, DOI: 10.1109/AERO.2013.6496943 ISBN: 978-1-4673-1812-9

## Beschreibung

Die Erfindung betrifft einen Elektroadhäsionsgreifer zum Halten von Werkstücken,
umfassend eine erste Elektrode und eine zweite Elektrode, die in einer Aufsicht auf die Elektroden ineinander greifend ausgebildet sind.

Elektroadhäsionsgreifer werden dazu eingesetzt, Werkstücke an einer Adhäsionsfläche festzuhalten, etwa zum Transport der Werkstücke in industriellen Produktionsprozessen, insbesondere verketteten Produktionsprozessen.

An der Adhäsionsfläche ist zumindest eine Elektrode ausgebildet, an die eine Hochspannung angelegt wird, so dass zwischen der Elektrode und der Umgebung ein starkes elektrisches Feld herrscht. Ein Werkstück, das an der Adhäsionsfläche anliegt, bleibt bei eingeschaltetem elektrischen Feld aufgrund von elektrostatischer Anziehung zu Gegenladungen, die im Werkstück induziert werden, an der Adhäsionsfläche haften. Die Elektrode kann von einer dünnen, isolierenden Folie vor einem unmittelbaren Kontakt mit dem Werkstück geschützt werden. Bei einem leitfähigen Werkstück werden zudem typischerweise zwei Elektroden eingesetzt, an die eine wechselnde Hochspannung angelegt wird.

Typische Elektroden für Elektroadhäsionsgreifer weisen eine kammartige Struktur auf. Die Haltekraft auf ein Werkstück parallel zur Adhäsionsebene weist dann eine Vorzugsrichtung auf: Parallel zu den Zinken des Kamms ist die Haltekraft deutlich kleiner als senkrecht zu den Zinken. Diese Anisotropie ist meist unerwünscht, insbesondere wenn die Orientierung von zu ergreifenden Werkstücken variiert, da die Haltekraft bei ungünstigen Umständen sehr klein ausfallen kann, insbesondere zu klein für einen sicheren Griff. Typische Elektroadhäsionsgreifer sind beispielsweise in WO 2007/143662 A2, oder DE 695 23 393 T2 offenbart. Ein Beispiel eines Elektroadhäsionsgreifer mit Elektroden die ein fraktales Muster ausbilden ist in DE 10 2014 215 333 B3 offenbart.

### Aufgabe der Erfindung

Der Erfindung liegt die Aufgabe zugrunde, einen Elektroadhäsionsgreifer bereitzustellen, mit dem zuverlässig eine richtungsunabhängige, hohe Haltekraft auf ein Werkstück parallel zur Adhäsionsfläche zur Verfügung gestellt werden kann.

### Kurze Beschreibung der Erfindung

Diese Aufgabe wird gelöst durch einen Elektroadhäsionsgreifer zum Halten von Werkstücken, umfassend eine erste Elektrode und eine zweite Elektrode, die in einer Aufsicht auf die Elektroden ineinander greifend ausgebildet sind,
wobei zumindest in einem Teilbereich in der Aufsicht auf die Elektroden die erste Elektrode und die zweite Elektrode ausgebildet sind entsprechend den Randlinien einer zweidimensionalen fraktalen raumfüllenden Kurve von zweiter oder höherer Ordnung.

Die vorliegende Erfindung schlägt vor, die Elektroden eines Elektroadhäsionsgreifers auf Basis eines fraktalen Musters auszubilden. Durch das fraktale Muster ist es möglich, Vorzugsrichtungen bei der Haltekraft parallel zur Adhäsionsfläche gut zu vermeiden. Dies gilt auch für Werkstücke, die außerhalb eines Zentrums der Elektrode ergriffen werden oder deutlich kleiner sind als die Elektroadhäsionsfläche.

Weiterhin ist vorgesehen, die erste und die zweite Elektrode gemäß den Randlinien (also einer Einfassung) einer zweidimensionalen fraktalen raumfüllenden Kurve bzw. jeweiligen Teilen der Randlinien (der Einfassung) auszubilden. Die beiden Elektroden bilden also nicht die raumfüllende Kurve selbst nach. Dadurch ist es möglich, mit besonders geringen Isolationsbreiten zwischen den Elektroden bzw. mit einem besonders geringen Anteil an Isolationsflächen zwischen den Elektroden im Vergleich zur gesamten Adhäsionsfläche auszukommen. Dies ermöglicht größere elektrische Feldstärken und/oder größere Elektrodenlängen, was für eine größere Haltekraft genutzt werden kann. Eine bipolare Elektrodengeometrie ist für die Elektroadhäsion im Rahmen der Erfindung sehr gut geeignet.

Der erfindungsgemäße Elektroadhäsionsgreifer kann universell für verschiedene Werkstückgrößen, Werkstückgeometrien und Werkstückorientierungen eingesetzt werden, insbesondere auch in einem flexiblen Elektroadhäsionsgreifer (mit flexibler Isolationsschicht, ggf. auch flexibler Stützstruktur).

Die Elektrodengeometrien können grundsätzlich beliebig klein skaliert werden (durch eine entsprechend hohe Dimension der raumfüllenden Kurve). Die Elektroden besitzen kein regelmäßiges großskaliges Muster. Die elektrischen Felder im Zwischenraum der Elektroden sind maximal unterschiedlich orientiert. Typische Stanz-/Laserteile, die mit dem Elektroadhäsionsgreifer gehandhabt werden, haben eine fraktale Dimension zwischen 1,3 und 1,6 und damit eine stark unterschiedliche Dimension zu den Elektroden des Greifers (mit Dimension 2). Maximal viele Elektrodenzwischenräume können in allen Richtungen gleichmäßig vom Werkstück überdeckt werden.

Die Randlinien ergeben sich durch beidseitiges Umschließen des Verlaufs der raumfüllenden Kurve auf einem Hilfsgitter, das gegenüber einem Gitter der raumfüllenden Kurve um einen halben Gitterabstand in jede Gitterrichtung versetzt ist. Die Umschließung ist für eine Aufteilung auf die beiden Elektroden an (wenigstens) zwei Stellen unterbrochen, bevorzugt wobei der Anfang (erstes Ende) und das Ende (zweites Ende) der raumfüllenden Kurve nicht vollständig umschlossen sind. Dadurch ergeben sich zwei separate Strukturen von zusammenhängenden Randlinien für die beiden Elektroden. Die Randlinien ergeben sich auch durch ein maximales Verbreitern der raumfüllenden Kurve, so dass diese gerade an sich selbst stößt, aus der Außenkontur der raumfüllenden Kurve, wobei etwa am Anfang und am Ende der raumfüllenden Kurve jeweils eine Unterbrechung vorgesehen wird.

Die fraktale raumfüllende Kurve basiert im Allgemeinen auf einem Grundelement (Grundkurve, Generator), das über in linearer Abfolge miteinander verbundene Punkte auf einem Gitter definiert ist (im Falle einer Hilbert-Kurve beispielsweise ein "U" in einem 2x2-Gitter). Beim Übergang in die nächst höhere Ordnung wird jeder Gitterpunkt eines Grundelements durch ein verkleinertes Grundelement ersetzt; die verkleinerten Grundelemente sind dabei so orientiert, dass ihre Anfänge und Enden für eine gegenseitige Verbindung nebeneinander liegen, entsprechend der Verbindung der Gitterpunkte des ersetzten (größeren) Grundelements. Das Grundelement allein stellt die erste Ordnung (Iteration) der raumfüllenden Kurve dar. Nach Ersetzen von dessen Gitterpunkten durch verkleinerte Grundstrukturen wird die zweite Ordnung (Iteration) erhalten, durch Ersetzen der Gitterpunkte der verkleinerten Grundstrukturen die dritte Ordnung (Iteration), und so fort.

Fraktale Grundstrukturen sind beispielsweise in den folgenden Dokumenten beschrieben: EP 2 413 347 A1, US 2014/0272272 A1.

Der Verlauf der Elektroden entsprechend der Randlinien (Randstruktur) der fraktalen raumfüllenden Kurve wird in einer Aufsicht (Projektion) auf die Elektroden von der werkstückzugewandten Adhäsionsfläche des Elektroadhäsionsgreifers aus, in Richtung senkrecht zur Adhäsionsfläche, ausgebildet. In dieser Aufsicht (Projektion) greifen die Elektroden auch ineinander. Man beachte, dass die Elektroden in einer gemeinsamen Ebene oder auch in verschiedenen Ebenen angeordnet sein können; ebenso ist eine Verteilung einer jeweiligen Elektrode auf mehrere Ebenen möglich, falls gewünscht.

### Bevorzugte Ausführungsformen der Erfindung

Bei einer bevorzugten Ausführungsform des erfindungsgemäßen Elektroadhäsionsgreifers, die vorsieht, dass die erste Elektrode und die zweite Elektrode ausgebildet sind entsprechend einem ersten Teil und einem zweiten Teil der Randlinien der raumfüllenden Kurve, wobei der erste Teil und der zweite Teil der Randlinien im Bereich eines Anfangs und im Bereich eines Endes der raumfüllenden Kurve voneinander getrennt sind. Bei einer Unterbrechung der Randlinien am Anfang und am Ende der raumfüllenden Kurve können die Randlinien (bzw. kann die Einfassung) der raumfüllenden Kurve auf einfache Weise auf lediglich zwei Elektroden aufgeteilt werden, so dass auch insgesamt nur zwei Anschlüsse für die beiden Elektroden benötigt werden. Jeder Abschnitt der raumfüllenden Kurve wird zu seinen beiden Seiten von verschiedenen Elektroden umgriffen, auch am Anfang und am Ende, so dass Änderungen der Richtung des lokalen elektrischen Felds auf minimalem Raum stattfinden können.

Vorteilhaft ist eine Ausführungsform, bei der die raumfüllende Kurve von dritter oder höherer Ordnung, bevorzugt von vierter oder höherer Ordnung ist. Dadurch ist es möglich, auch im Vergleich zu den Elektroden sehr kleine Strukturen sicher zu ergreifen.

Bevorzugt ist weiterhin eine Ausführungsform, bei der die raumfüllende Kurve eine Hilbert-Kurve ist. Elektrodenauslegungen auf Basis einer Hilbert-Kurve sind vergleichsweise einfach zu planen und umzusetzen. Alternativ können auch andere Typen von FASS-Kurven im Rahmen der Erfindung als raumfüllende Kurven eingesetzt werden, etwa eine Peano-Kurve. Im Allgemeinen sind raumfüllende Kurven, deren Grundelement auf einem 2x2 oder 3x3-Gitter darstellbar ist, bevorzugt.

Ebenfalls bevorzugt ist eine Ausführungsform, bei der der Elektroadhäsionsgreifer genau zwei Elektroden, nämlich die erste Elektrode und die zweite Elektrode, aufweist. Dadurch bleibt der Aufbau des Elektroadhäsionsgreifers besonders einfach. Insbesondere sind lediglich zwei Anschlüsse in der gemeinsamen Ebene der Elektroden nötig.

Bei einer vorteilhaften Ausführungsform sind die erste Elektrode und die zweite Elektrode an Enden und/oder Ecken ihrer jeweiligen Randlinien abgerundet ausgebildet. Dies vermeidet Feldstärkespitzen bzw. Spannungsdurchschläge an den Elektroden bei hohen Spannungen. Bevorzugt ist der Krümmungsradius an den Abrundungen größer als 1/10 der lokalen Breite der Elektrode, besonders bevorzugt größer als 1/4 der lokalen Breite der Elektrode.

Bevorzugt ist weiterhin eine Ausführungsform, bei der ein kleinster Abstand zwischen der ersten Elektrode und der zweiten Elektrode in der Aufsicht auf die Elektroden 3,0 mm oder weniger, bevorzugt 1,0 mm oder weniger, besonders bevorzugt 0,3 mm oder weniger, beträgt. Mit einem geringen (kleinsten) Abstand können hohe elektrische Feldstärken und damit hohe Haltekräfte erreicht werden. Die angegebenen Abstände sind für typische Anwendungen wie das Ergreifen von Metallblechen gut geeignet.

Ebenfalls bevorzugt ist eine Ausführungsform, bei der in dem Teilbereich in der Aufsicht auf die Elektroden die erste Elektrode und die zweite Elektrode mit einer einheitlichen Breite ausgebildet sind. Dies vereinfacht den Aufbau und sorgt für eine gleichmäßige Verteilung der Haltekraft in der Adhäsionsfläche. Lokale Stromstärkespitzen werden vermieden.

Bevorzugt ist auch eine Ausführungsform, bei der in dem Teilbereich in der Aufsicht auf die Elektroden die erste Elektrode und/oder die zweite Elektrode auf eine dielektrische, isolierende Folie aufgedruckt sind, und die Folie an eine Halterstruktur aufgeklebt ist. Dieses Herstellungsverfahren ist in der Praxis bewährt und auch mit dem erfindungsgemäßen Elektrodenaufbau gut umsetzbar. Die Halterstruktur wird typischerweise an einer Automatisierungseinheit (etwa mit einem Roboterarm) angebracht.

Vorteilhaft ist weiterhin eine Ausführungsform, bei der in dem Teilbereich die erste Elektrode und die zweite Elektrode in einer gemeinsamen Ebene angeordnet sind. Dies ist einfach zu fertigen, und es lassen sich besonders hohe Feldstärken für eine große Haltekraft erzeugen.

Ebenfalls ist vorteilhaft ist eine Ausführungsform, bei der in dem Teilbereich die erste Elektrode in einer ersten Ebene und die zweite Elektrode in einer zweiten Ebene angeordnet sind, wobei die erste Ebene und die zweite Ebene koplanar und voneinander beabstandet angeordnet sind. Bei dieser Bauform ist die Isolation zwischen den Elektroden besonders einfach zu gewährleisten; zudem ist der Aufbau vergleichsweise einfach. Der Abstand zwischen den beiden Ebenen, gemessen senkrecht zu den Ebenen, beträgt typischerweise nur 10 µm bis 200 µm und wird meist durch die Dicke einer Kunststofffolie bestimmt.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Ansicht einer Hilbert-Kurve erster Ordnung, mit Randlinien, zur Erläuterung der Konstruktion einer erfindungsgemäßen Elektrodengeometrie;
- Fig. 2: eine schematische Ansicht einer Hilbert-Kurve zweiter Ordnung, mit Randlinien, zur Erläuterung der Konstruktion einer erfindungsgemäßen Elektrodengeometrie;
- Fig. 3: eine schematische Ansicht einer Hilbert-Kurve dritter Ordnung, mit Randlinien, zur Erläuterung der Konstruktion einer erfindungsgemäßen Elektrodengeometrie;
- Fig. 4: eine schematische Ansicht einer Elektrodengeometrie, abgeleitet aus Fig. 3, für einen erfindungsgemäßen Elektroadhäsionsgreifer;
- Fig. 5: eine schematische Ansicht der Elektrodengeometrie von Fig. 4, jedoch mit abgerundeten Enden und Ecken, mit Erläuterung der elektrischen Felder;
- Fig. 6: eine schematische Ansicht einer Elektrodengeometrie auf Basis einer Hilbert-Kurve vierter Ordnung, für einen erfindungsgemäßen Elektroadhäsionsgreifer;
- Fig. 7: eine schematische Ansicht der Elektrodengeometrie von Fig. 6, mit Überdeckung durch ein Werkstück mit mehreren konzentrischen Ringstrukturen;
- Fig. 8: eine schematische Ansicht der Elektrodengeometrie von Fig. 6, mit Überdeckung durch ein Werkstück mit einer regelmäßigen Gitterstruktur;
- Fig. 9a: eine schematische Querschnitts-Ansicht eines erfindungsgemäßen Elektroadhäsionsgreifers beim Ergreifen eines Werkstücks, mit erster und zweiter Elektrode in einer gemeinsamen Ebene;
- Fig. 9b: eine schematische Querschnitts-Ansicht eines erfindungsgemäßen Elektroadhäsionsgreifers beim Ergreifen eines Werkstücks, mit erster und zweiter Elektrode in koplanaren Ebenen;
- Fig. 10: eine schematische Ansicht einer Peano-Kurve erster Ordnung, mit Randlinien, zur Erläuterung der Konstruktion einer erfindungsgemäßen Elektrodengeometrie;
- Fig. 11: eine schematische Ansicht der Peano-Kurve von Fig. 10, um einen Faktor 3 verkleinert;
- Fig. 12: eine schematische Ansicht einer Peano-Kurve zweiter Ordnung, mit Randlinien, zur Erläuterung der Konstruktion einer erfindungsgemäßen Elektrodengeometrie.

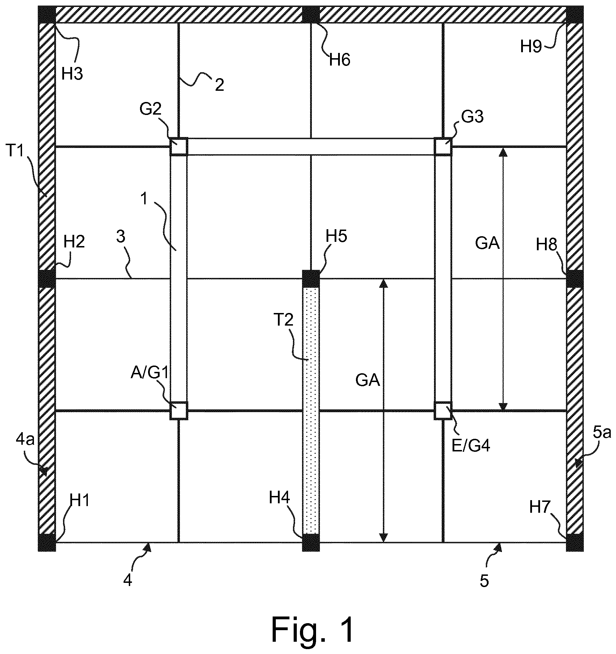

Die Figuren 1 bis 3 erläutern beispielhaft anhand einer Hilbert-Kurve, wie im Rahmen der Erfindung Elektrodengeometrien für einen Elektroadhäsionsgreifer gefunden werden können.

Die **Fig. 1** zeigt zunächst (mit weißen, ungefüllten Balken) eine Hilbert-Kurve erster Ordnung 1 (Grundkurve, Generator). Die Ordnung wird auch als Iteration bezeichnet.

Auf einem Gitter 2 (mit dicken schwarzen Linien gezeichnet) liegen in quadratischer Anordnung vier Gitterpunkte G1, G2, G3, G4 (so genannte 2x2-Anordnung). Diese Gitterpunkte G1-G4 (mit leeren, weißen Quadraten gezeichnet) werden durch die Hilbert-Kurve 1 in linearer Folge verbunden. Die Hilbert-Kurve erster Ordnung 1 hat die Form eines (hier umgedrehten) U. Sie beginnt an einem Anfang A bei Gitterpunkt G1 und endet an einem Ende E bei Gitterpunkt G4.

Auf einem Hilfsgitter 3 (mit dünnen schwarzen Linien gezeichnet) liegen in einem quadratischen Raster hier insgesamt neun Hilfsgitterpunkte H1-H9 (mit schwarzen Quadraten gezeichnet). Das Hilfsgitter 3 weist den betragsmäßig gleichen Gitterabstand GA auf wie das Gitter 2, ist aber diesem gegenüber um einen halben Gitterabstand in beide Gitterrichtungen des Gitters 2 (also nach rechts und oben) versetzt.

Der Verlauf der Hilbert-Kurve erster Ordnung 1 kann nun durch Randlinien auf dem Hilfsgitter 3 umschlossen werden. Man beachte, dass nur Hilfsgitterpunkte H1-H9 benötigt werden, die (diagonal) benachbart zu Gitterpunkten G1-G4 des Gitters liegen. Die Randlinien verbinden dabei alle im Hilfsgitter 3 gerade (nach rechts links oder aber nach oben/unten) zueinander benachbarten Hilfsgitterpunkte H1-H9 miteinander, deren jeweilige Verbindung nicht von der Hilbert-Kurve 1 gekreuzt wird. Dabei wird jedoch wenigstens eine randseitige Verbindung 4 am Anfang A (beim Gitterpunkt G1) und eine randseitige Verbindung 5 am Ende E (beim Gitterpunkt G4) offen gelassen. Man beachte, dass alternativ auch die Verbindungen 4a, 5a anstelle der Verbindungen 4, 5 offen gelassen werden könnten, oder alle Verbindungen 4, 4a, 5, 5a offengelassen werden könnten.

Die Umschließung ergibt dann einen ersten Teil T1 (schraffiert eingezeichnet) der Randlinien, der hier die Hilfsgitterpunkte H1, H2, H6, H9, H8, H7 entlang des Hilfsgitters 3 verbindet. Die Umschließung ergibt weiterhin einen zweiten Teil T2 (gepunktet eingezeichnet) der Randlinien, der hier die Hilfsgitterpunkte H4, H5 entlang des Hilfsgitters 3 verbindet.

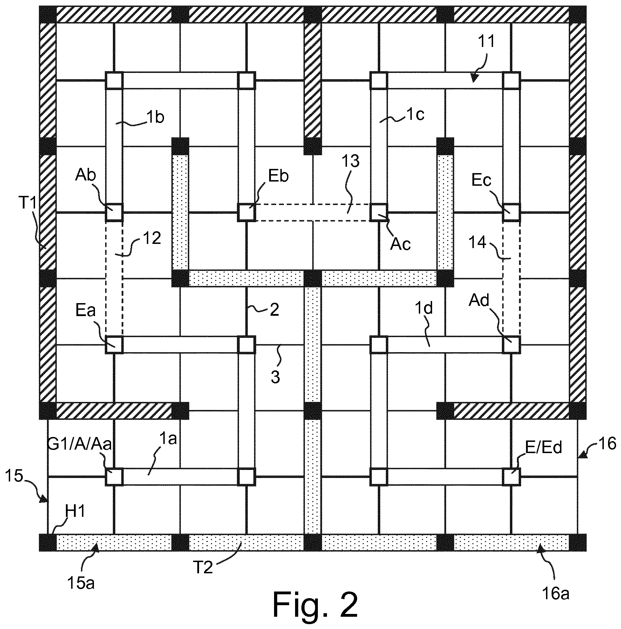

Um zur Hilbert-Kurve zweiter Ordnung 11 zu gelangen, wird nun jeder Gitterpunkt G1-G4 aus Fig. 1 durch eine entsprechend (hier um den Faktor 2) verkleinerte Hilbert-Kurve der ersten Ordnung 1a-1d ersetzt, vgl. hierzu Fig. 2. Die verkleinerten Hilbert-Kurven der ersten Ordnung 1a-1d werden über ihre Anfänge Aa-Ad und Enden Ea-Ed mit Verbindungen 12, 13, 14 so verbunden, wie die Gitterpunkte G1-G4 in der ursprünglich orientierten Hilbert-Kurve erster Ordnung 1 der Voriteration (siehe Fig. 1) verbunden waren. Die Orientierung einer jeweiligen verkleinerten Hilbert-Kurve erster Ordnung 1a-1d ist dafür entsprechend zu wählen, etwa durch Drehung und/oder Spiegelung (wobei hier Drehungen genügen). Konkret wird ist die Hilbert-Kurve 1a (ehemals Gitterpunkt G1) über die Verbindung 12 mit der Hilbert-Kurve 1b (ehemals Gitterpunkt G2) verbunden. Weiterhin ist die Hilbert-Kurve 1b (ehemals Gitterpunkt G2) über die Verbindung 13 mit der Hilbert-Kurve 1c (ehemals Gitterpunkt G3) verbunden. Schließlich ist die Hilbert-Kurve 1c (ehemals Gitterpunkt G3) über die Verbindung 14 mit der Hilbert-Kurve 1d (ehemals Gitterpunkt G4) verbunden. Man beachte, dass die iterative Konstruktion von zweidimensionalen fraktalen raumfüllenden Kurven (wie der Hilbert-Kurve) als solches bekannt ist.

Für die Hilbert-Kurve zweiter Ordnung 11, deren insgesamt 16 Gitterpunkte (vgl. weiß gefüllte Quadrate, beispielhaft ist G1 eingezeichnet) wiederum auf einem Gitter 2 (mit dicken schwarzen Linien) liegen, können nun wiederum die Randlinien ergänzt werden. Dazu wird ein Hilfsgitter 3 (mit dünnen schwarzen Linien), das in jede Gitterrichtung um einen halben Gitterabstand versetzt zum Gitter 2 ist, mit Hilfsgitterpunkten (ausgefüllte, schwarze Quadrate, beispielhaft ist H1 eingezeichnet) eingesetzt. Zur Konstruktion der Randlinien werden alle zueinander (gerade) benachbarten Hilfsgitterpunkte miteinander verbunden, sofern deren Verbindung nicht die Hilbert-Kurve 11 (einschließlich deren Verbindungen 12, 13, 14) kreuzt. Benachbart zum Gitterpunkt des Anfangs A und zum Gitterpunkt des Endes E der Hilbert-Kurve 11 bleibt jeweils zumindest eine außen liegende Verbindung 15, 16 offen; alternativ oder zusätzlich könnten auch die Verbindungen 15a, 16a offen bleiben.

Es ergibt sich ein erster Teil T1 der Randlinien (schraffiert eingezeichnet) und ein zweiter Teil T2 der Randlinien (gepunktet eingezeichnet), die voneinander separat sind. Die Teile T1 und T2 der Randlinien zur Hilbert-Kurve zweiter Ordnung 11 können bereits für eine Konstruktion von Elektroden eines Elektroadhäsionsgreifers verwendet werden. Meist wird jedoch eine raumfüllende Kurve wenigstens dritter Ordnung als Grundlage für die Elektrodenkonstruktion herangezogen.

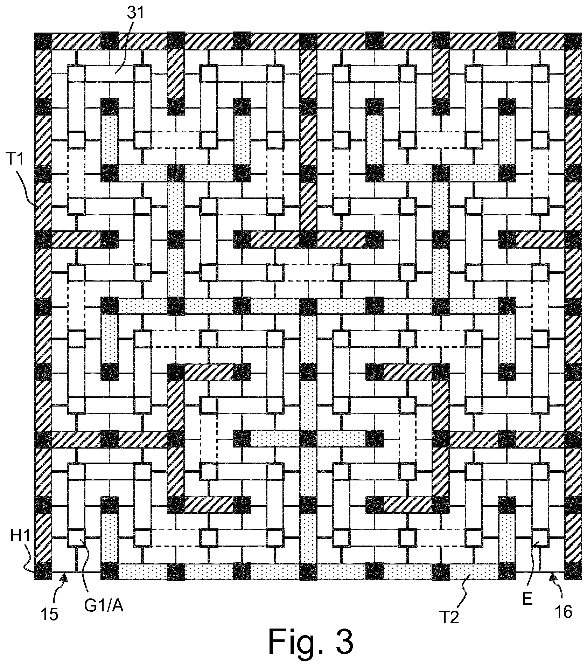

In analoger Weise wie von der ersten zur zweiten Ordnung kann auch für die Konstruktion von der zweiten zur der dritten Ordnung (und entsprechend noch höheren Ordnungen) der Hilbert-Kurve vorgegangen werden. Die Fig. 3 illustriert die Konstruktion der Hilbert-Kurve der dritten Ordnung 31, wobei jeweils die Gitterpunkte (leere, weiße Quadrate in Fig. 2) der Hilbert-Kurve der zweiten Ordnung 11 durch eine verkleinerte Hilbert-Kurve erster Ordnung ersetzt wurden, die geeignet orientiert ist, um die in der Hilbert-Kurve zweiter Ordnung 11 vorgesehenen Verbindungen zu übernehmen. Die Hilbert-Kurve dritter Ordnung 31 verläuft raumfüllend auf insgesamt 64 Gitterpunkten (siehe weiße Quadrate, beispielhaft ist Gitterpunkt G1 eingezeichnet).

Über ein Hilfsgitter 3, das gegenüber dem Gitter 2 der Hilbert-Kurve dritter Ordnung 31 in jede Richtung um einen halben Gitterabstand versetzt ist, und dessen Hilfsgitterpunkte (schwarze Quadrate, beispielhaft ist der Hilfsgitterpunkt H1 eingezeichnet) können die Randlinien mit den zwei getrennten Teilen T1 und T2 erhalten werden. Die (gerade) benachbarten Hilfsgitterpunkte werden verbunden, ohne die Hilbert-Kurve 81 zu kreuzen, wobei hier die Verbindungen 15, 16 am Anfang A und am Ende E offengelassen werden.

Man beachte, dass jeder Hilfsgitterpunkt auf dem Teil T1 wenigstens einen diagonal oder gerade benachbarten Hilfsgitterpunkt auf dem Teil T2 hat und umgekehrt.

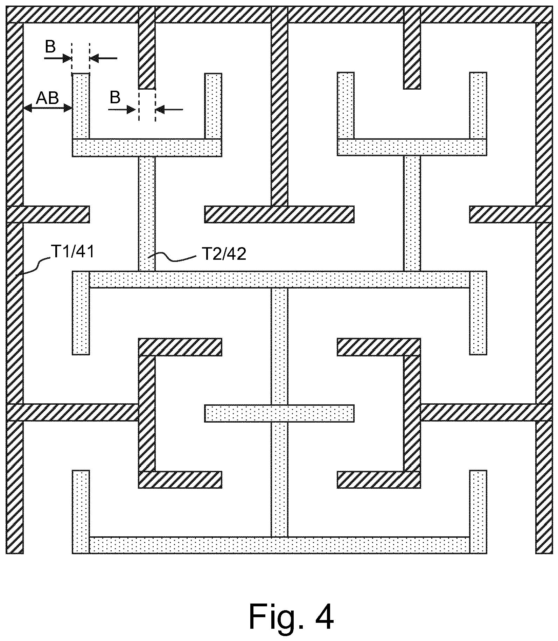

In der **Fig. 4** sind zur besseren Übersicht nur die Teile T1 (schraffiert) und T2 (gepunktet) der Randlinien von Fig. 3 dargestellt. Diese können als Vorlage für die Geometrie einer ersten Elektrode 41 und einer zweiten Elektrode 42 für einen erfindungsgemäßen Elektroadhäsionsgreifer genutzt werden. Die Elektroden 41, 42 sind dabei in Aufsicht von einer werkstückzugewandten Adhäsionsfläche des Elektroadhäsionsgreifers aus dargestellt; die beiden Elektroden 41, 42 liegen hier in einer gemeinsamen Ebene (alternativ können aber die Elektroden auch beispielsweise in hintereinander liegenden Ebenen angeordnet sein). Der Raum zwischen den Elektroden 41, 42 dient der elektrischen Isolation zwischen den Elektroden und kann beispielsweise mit einem isolierenden Kunststoff verfüllt oder einfach frei gelassen werden. Die Elektroden 41, 42 bestehen meist aus Kupfer, Gold oder Silber oder Legierungen, die diese Metalle enthalten. Man beachte, dass die Breite B der Elektroden 41, 42 grundsätzlich beliebig gewählt werden kann (solange die erforderliche Isolation zwischen den Elektroden 41, 42 gewährleistet ist). Typischerweise sind aber die Breiten B der Elektroden 41, 42 bei beiden Elektroden 41, 42 und auch innerhalb einer jeweiligen Elektrode 41, 42 gleich. Entsprechend ist auch in Aufsicht auf die Elektroden 41, 42 der (kleinste) Abstand AB zwischen den Elektroden 41, 42 typischerweise überall gleich.

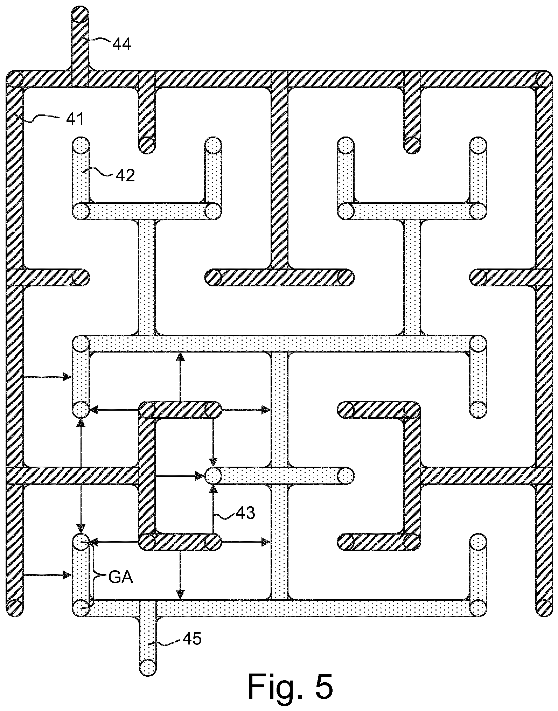

Bei Verwendung hoher Spannungen zwischen den Elektroden 41, 42 können die Ecken der Elektroden 41, 42 (einschließlich der Ecken an den Enden der Elektroden 41, 42) abgerundet ausgebildet werden. In der in **Fig. 5** gezeigten Bauform, die weitgehend der Bauform von Fig. 4 entspricht, sind alle äußeren Ecken abgerundet, hier mit einem Krümmungsradius entsprechend einer halben Elektrodenbreite. In gleicher Weise sind die inneren Ecken abgerundet ausgebildet. Dadurch werden Spannungsüberschläge vermieden bzw. erschwert.

Die Fig. 5 illustriert auch zusätzlich die verschiedenen Orientierungen von lokalen elektrischen Feldern (beispielhaft ist die Feldlinie 43 markiert), die sich im Rahmen der Nutzung der Elektroden 41, 42 auf unterschiedlichen Potentialen einstellen. Die Orientierungen variieren über sehr kurze Distanzen, so dass spätestens nach ca. einem Gitterabstand GA eine Änderung der Feldrichtung einsetzt. Weiterhin sind noch zwei elektrische Anschlüsse 44, 45 der Elektroden 41, 42 zu einer Hochspannungsquelle (nicht eingezeichnet) dargestellt. Die Anschlüsse 44, 45 befinden sich (zumindest teilweise) in der gemeinsamen Ebene (hier der Zeichenebene) der Elektroden 41, 42. Die räumliche Anordnung der Anschlüsse 44, 45 ist den geometrischen Gegebenheiten des Elektroadhäsionsgreifers geschuldet und ist nicht durch die raumfüllende Kurve oder deren Randlinien bedingt. Mit anderen Worten, nur in dem Teilbereich in der Aufsicht auf die Elektroden 41, 42 ohne die Anschlüsse 44, 45 entsprechen hier die Elektroden 41, 42 den Randlinien der fraktalen raumfüllenden Kurve.

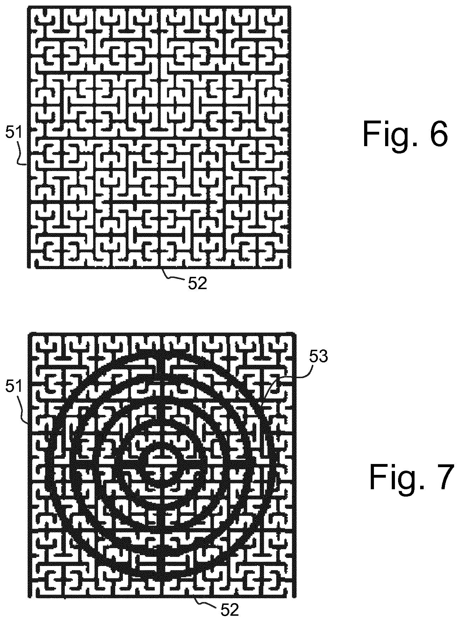

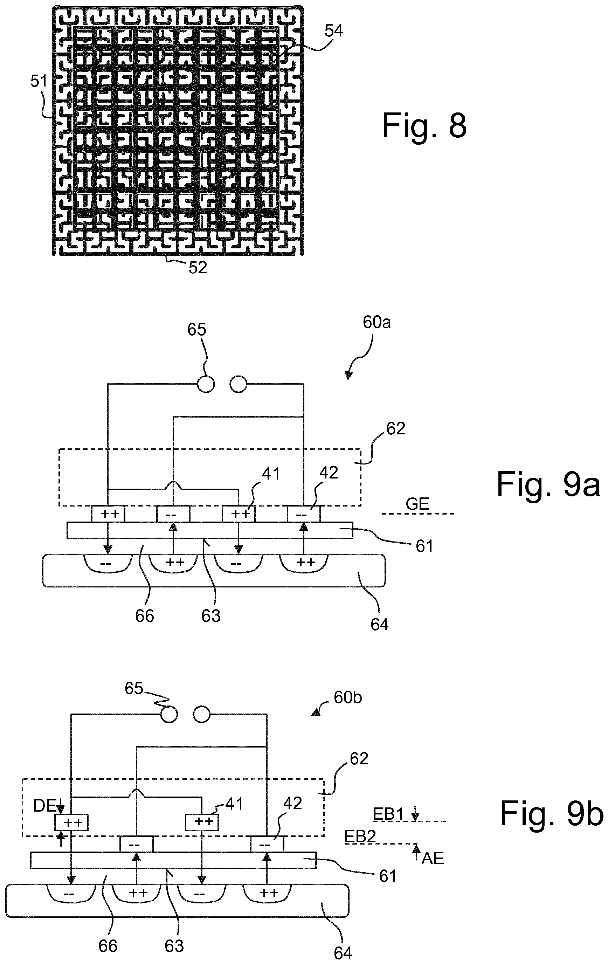

Die **Fig. 6** zeigt eine Elektrodenanordnung für die Erfindung mit einer ersten Elektrode 51 und einer zweiten Elektrode 52 auf Basis einer Hilbert-Kurve vierter Ordnung. Bei Überdeckung mit einem Werkstück 53, das in **Fig. 7** mit mehreren konzentrischen, kreisringartigen Strukturen ausgebildet ist, sind die elektrischen Feldlinien in sehr vielen (z. B. mehr als 30) lokalen Elektroden-Zwischenräumen näherungsweise mit gleichen Anteilen in allen Richtungen (insbesondere in Richtung links-rechts und oben-unten) anzutreffen, und es besteht keine merkliche Vorzugsrichtung der Haltekraft in der Ebene der Elektroden 51, 52 (hier der Zeichenebene). Auch bei Überdeckung mit einem Werkstück 54 mit einer regelmäßigen quadratischen Gitterstruktur, vgl. **Fig. 8****,** werden Feldlinien in sehr vielen (z.B. mehr als 30) lokalen Elektroden-Zwischenräumen aller Orientierungen mit näherungsweise gleichen Anteilen überdeckt, so dass es wiederum eine in allen Richtungen im Wesentlichen gleiche, hohe Haltekraft gibt.

**Fig. 9a** zeigt schematisch einen erfindungsgemäßen Elektroadhäsionsgreifer 60a im Querschnitt. Auf einer isolierenden Folie (dielektrischen Folie) 61, etwa aus PET, PEN oder PI, sind zwei Elektroden 41, 42 aufgedruckt, etwa mit einer in Fig. 4 oder Fig. 5 illustrierten Geometrie. Man beachte, dass jede Elektrode 41, 42 im gezeigten Querschnitt mehrfach geschnitten wird, jedoch die jeweilige Elektrode 41, 42 in sich zusammenhängend ist, so dass alle Elektrodenteile derselben Elektrode 41, 42 auf gleichem Potential sind (hier angedeutet durch die elektrischen Verbindungen der Elektrodenteile). Die Elektroden 41, 42 sind (von Zuleitungen abgesehen) in der gezeigten Ausführungsform in einer gemeinsamen Ebene GE angeordnet. Die isolierende Folie 61 samt Elektroden 41, 42 ist an einer Halterstruktur (auch genannt Stützstruktur) 62 befestigt, wobei die Isolationsfolie 61 die Elektroden 41, 42 nach außen hin abdeckt. Die Elektroden 41, 42 sind weiterhin im Allgemeinen auch gegenüber der Halterstruktur 62 elektrisch isoliert, beispielsweise durch eine weitere Isolationsfolie (nicht näher dargestellt). Die Vorderseite der Isolationsfolie 61 bildet eine Greiffläche (auch genannt Adhäsionsfläche) 63 aus, an die ein Werkstück 64 (hier ein Metallblech) angelegt werden kann. Die Elektrode 41 ist beispielhaft auf positives Potential und die Elektrode 42 auf negatives Potential durch eine Hochspannungsquelle 65 geschaltet. Die Elektroden 41, 42 induzieren hier über einen Luftspalt 66 hinweg Gegenladungen mit jeweils umgekehrtem Vorzeichen im Werkstück 64, wodurch es zu einer elektrostatischen Anziehung zwischen dem Elektroadhäsionsgreifer 60a und dem Werkstück 64 kommt. Entsprechend wird, solange die Hochspannung an den Elektroden 41, 42 anliegt, das Werkstück 64 am Elektroadhäsionsgreifer 60a gehalten. Der Elektroadhäsionsgreifer 60a ist typischerweise mit einer Automatisierungseinheit (etwa einem Roboterarm) ausgebildet (nicht näher dargestellt), um das Werkstück 64 zu transportieren.

**Fig. 9b** zeigt schematisch einen alternativen erfindungsgemäßen Elektroadhäsionsgreifer 60b im Querschnitt. Im Unterschied zu dem Elektroadhäsionsgreifer 60a aus Fig. 9a liegt hier die Elektrode 41 in einer ersten Ebene EB1 (in der gezeigten Ausführungsform innerhalb der Halterstruktur 62), und die zweite Elektrode 42 liegt in einer zweiten Ebene EB2 und ist auf die Isolationsfolie 61 aufgedruckt. Die Ebenen EB1, EB2 sind koplarar (parallel zueinander) ausgebildet, und die Elektroden 41, 42 liegen hintereinander. Ein Abstand AE der Ebenen EB1, EB2, gemessen jeweils von Mitte zu Mitte der Elektroden 41, 42, ist hier geringfügig größer als die Dicke DE der Elektroden EB1, EB2.

Wird in Fig. 9a oder Fig. 9b von der Seite der Greiffläche (Adhäsionsfläche) 63 in Richtung senkrecht zu der Greiffläche (Adhäsionsfläche) 63 auf den Elektroadhäsionsgreifer 60a, 60b geblickt, so ergibt sich in dieser Aufsicht bzw. in Projektion auf die Greiffläche (Adhäsionsfläche) 63 die Elektrodengeometrie gemäß der Erfindung, wie sie etwa in Fig. 4 oder Fig. 5 dargestellt ist.

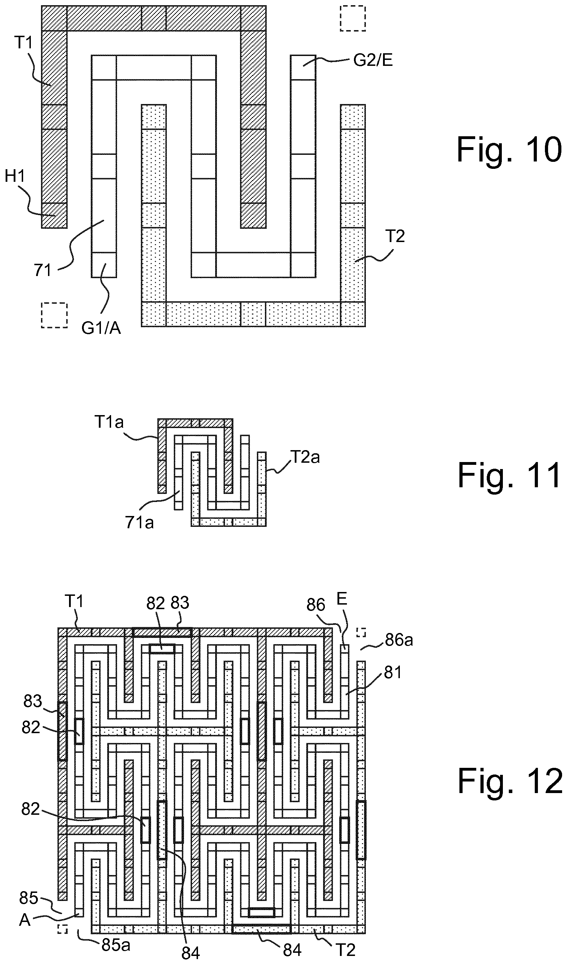

Die Figuren 10 bis 12 erläutern die Konstruktion von Elektrodengeometrien gemäß der Erfindung auf Basis einer Peanu-Kurve.

Die **Fig. 10** zeigt zunächst eine Peano-Kurve erster Ordnung 71, die auf insgesamt neun Gitterpunkten (eingezeichnet als leere, weiße Quadrate) eines Gitters in einer 3x3-Anordnung basiert; beispielhaft sind der Gitterpunkt G1, der gleichzeitig den Anfang A der Peano-Kurve erster Ordnung 71 darstellt, und der Gitterpunkt G2, der gleichzeitig deren Ende E darstellt, eingezeichnet. Die Gitterpunkte werden durch die Peano-Kurve linear in miteinander verbunden; die Peano-Kurve erster Ordnung 71 (erster Iteration) hat einen näherungsweise S-förmigen Verlauf.

Um einen halben Gitterabstand in jede Gitterrichtung versetzt können Hilfsgitterpunkte (schraffierte, gepunktete und gestrichelte Quadrate) angeordnet werden, von denen beispielhaft der Hilfsgitterpunkt H1 eingezeichnet ist. Die Verbindungen der gerade benachbarten Hilfsgitterpunkte (soweit sie nicht die Peano-Kurve 71 kreuzen würden) definieren Randlinien der Peano-Kurve 71. Weiterhin sind hier die außenliegenden Verbindungen benachbart zu Anfang A und Ende E weggelassen. Entsprechend ergeben sich Teile T1 (schraffiert) und T2 (gepunktet) der Randlinien.

Durch Ersetzen der Gitterpunkte durch eine hier um den Faktor 3 verkleinerte Peano-Kurve erster Ordnung 71a, vgl. **Fig. 11****,** kann die Peano-Kurve 81 zweiter Ordnung 81 erhalten werden, vgl. **Fig. 12****.** Die verkleinerten Peano-Kurven werden jeweils so orientiert, hier durch Spiegelungen, dass die Verbindungen der ursprünglichen Peano-Kurve erster Ordnung 71 eingerichtet werden können; man beachte hierzu die Verbindungen 82 (mit dicken Umrandungen) der Peano-Kurve zweiter Ordnung 81.

Setzt man die Peano-Kurve zweiter Ordnung 81 einschließlich der Teile T1a, T2a der Randlinien, die zu der verkleinerten Peano-Kurve erster Ordnung 71a gehören (vgl. Fig. 11), zusammen, so sollten auch diese Randlinien mit Verbindungen 83, 84 verbunden werden, um die Teile T1, T2 der Peano-Kurve zweiter Ordnung 81 zu erhalten. Die gleichen Randlinien bzw. deren Teile T1, T2 erhält man über die Hilfsgitterpunkte (schraffierte, gepunktete und gestrichelte Quadrate), die sich durch Verschiebung der Gitterpunkte (weiße Quadrate) um einen halben Gitterabstand in jede Gitterrichtung ergeben, durch Verbindung gerade benachbarter Hilfsgitterpunkte unter Vermeidung von Kreuzungen mit der Peano-Kurve 81 und unter Offenlassen hier jeweils der beiden außenliegenden Verbindungen 85, 85a, 86, 86a am Anfang A und am Ende E der Peano-Kurve 81.

Die beiden separaten Teile T1 (schraffiert) und T2 (gepunktet) der Randlinien der Peano-Kurve zweiter Ordnung 81 können als Elektrodengeometrie für einen Elektroadhäsionsgreifer gemäß der Erfindung dienen.

## Patentansprüche

1. Elektroadhäsionsgreifer (60a; 60b) zum Halten von Werkstücken (53; 54; 64),
umfassend eine erste Elektrode (41; 51) und eine zweite Elektrode (42; 52), die in einer Aufsicht auf die Elektroden (41, 42; 51, 52) ineinander greifend ausgebildet sind,
**dadurch gekennzeichnet dass** zumindest in einem Teilbereich in der Aufsicht auf die Elektroden (41, 42; 51, 52) die erste Elektrode (41; 51) und die zweite Elektrode (42; 52) ausgebildet sind entsprechend den Randlinien einer zweidimensionalen fraktalen raumfüllenden Kurve von zweiter oder höherer Ordnung, wobei sich die Randlinien insbesondere durch beidseitiges Umschließen des Verlaufs der raumfüllenden Kurve auf einem Hilfsgitter, das gegenüber einem Gitter der raumfüllenden Kurve um einen halben Gitterabstand in jede Gitterrichtung versetzt ist, ergeben.

2. Elektroadhäsionsgreifer (60a; 60b) nach Anspruch 1, **dadurch gekennzeichnet, dass** die erste Elektrode (41; 51) und die zweite Elektrode (42; 52) ausgebildet sind entsprechend einem ersten Teil (T1) und einem zweiten Teil (T2) der Randlinien der raumfüllenden Kurve, wobei der erste Teil (T1) und der zweite Teil (T2) der Randlinien im Bereich eines Anfangs (A) und im Bereich eines Endes (E) der raumfüllenden Kurve voneinander getrennt sind.

3. Elektroadhäsionsgreifer (60a; 60b) nach Anspruch 1 oder 2, **dadurch gekennzeichnet, dass** die raumfüllende Kurve von dritter oder höherer Ordnung, bevorzugt von vierter oder höherer Ordnung, ist.

4. Elektroadhäsionsgreifer (60a; 60b) nach einem der vorhergehenden Ansprüche, **dadurch gekennzeichnet, dass** die raumfüllende Kurve eine Hilbert-Kurve (11; 31) ist.

5. Elektroadhäsionsgreifer (60a; 60b) nach einem der vorhergehenden Ansprüche, **dadurch gekennzeichnet, dass** der Elektroadhäsionsgreifer (60) genau zwei Elektroden (41, 42; 51, 52), nämlich die erste Elektrode (41; 51) und die zweite Elektrode (42; 52), aufweist.

6. Elektroadhäsionsgreifer (60a; 60b) nach einem der vorhergehenden Ansprüche, **dadurch gekennzeichnet, dass** die erste Elektrode (41; 51) und die zweite Elektrode (42; 52) an Enden und/oder Ecken ihrer jeweiligen Randlinien abgerundet ausgebildet sind.

7. Elektroadhäsionsgreifer (60a; 60b) nach einem der vorhergehenden Ansprüche, **dadurch gekennzeichnet, dass** ein kleinster Abstand (AB) zwischen der ersten Elektrode (41; 51) und der zweiten Elektrode (42; 52) in der Aufsicht auf die Elektroden (41, 42; 51, 52) 3,0 mm oder weniger, bevorzugt 1,0 mm oder weniger, besonders bevorzugt 0,3 mm oder weniger, beträgt.

8. Elektroadhäsionsgreifer (60a; 60b) nach einem der vorhergehenden Ansprüche, **dadurch gekennzeichnet, dass** in dem Teilbereich in der Aufsicht auf die Elektroden (41, 42; 51, 52) die erste Elektrode (41; 51) und die zweite Elektrode (42; 52) mit einer einheitlichen Breite (B) ausgebildet sind.

9. Elektrodenadhäsionsgreifer (60a; 60b) nach einem der vorhergehenden Ansprüche, **dadurch gekennzeichnet, dass** in dem Teilbereich in der Aufsicht auf die Elektroden (41, 42; 51, 52) die erste Elektrode (41; 51) und/oder die zweite Elektrode (42; 52) auf eine dielektrische, isolierende Folie (61) aufgedruckt sind, und die Folie (61) an eine Halterstruktur (62) aufgeklebt ist.

10. Elektrodenadhäsionsgreifer (60a; 60b) nach einem der Ansprüche 1 bis 9, **dadurch gekennzeichnet, dass** in dem Teilbereich die erste Elektrode (41; 51) und die zweite Elektrode (42; 52) in einer gemeinsamen Ebene (GE) angeordnet sind.

11. Elektroadhäsionsgreifer (60a; 60b) nach einem der Ansprüche 1 bis 9, **dadurch gekennzeichnet, dass** in dem Teilbereich die erste Elektrode (41; 51) in einer ersten Ebene (EB1) und die zweite Elektrode (42; 52) in einer zweiten Ebene (EB2) angeordnet sind, wobei die erste Ebene (EB1) und die zweite Ebene (EB2) koplanar und voneinander beabstandet angeordnet sind.

12. Elektroadhäsionsgreifer (60a; 60b) nach einem der vorhergehenden Ansprüche, **dadurch gekennzeichnet, dass** die Umschließung für eine Aufteilung auf die beiden Elektroden an wenigstens zwei Stellen unterbrochen ist, wobei insbesondere der Anfang und das Ende der raumfüllenden Kurve nicht vollständig umschlossen sind

## Claims

1. Electroadhesion gripper (60a; 60b) for holding workpieces (53; 54; 64), comprising a first electrode (41; 51) and a second electrode (42; 52) that are designed to mutually engage in a plan view of the electrodes (41, 42; 51, 52), **characterised in that** at least in a sub-region in the plan view of the electrodes (41, 42; 51, 52), the first electrode (41; 52) and the second electrode (42; 52) are designed in accordance with the border lines of a two-dimensional fractal space-filling curve of a second or higher order, wherein the border lines in particular result from enclosing the shape of the space-filling curve on both sides on an auxiliary grid that is offset with respect to a grid of the space-filling curve by half a grid spacing in each grid direction.

2. Electroadhesion gripper (60a; 60b) according to claim 1, **characterised in that** the first electrode (41; 51) and the second electrode (42; 52) are designed in accordance with a first part (T1) and a second part (T2) of the border lines of the space-filling curve, the first part (T1) and the second part (T2) of the border lines being separated from one another in the region of a starting point (A) and in the region of an end point (E) of the space-filling curve.

3. Electroadhesion gripper (60a; 60b) according to either claim 1 or claim 2, **characterised in that** the space-filling curve is of a third or higher order, preferably of a fourth or higher order.

4. Electroadhesion gripper (60a; 60b) according to any one of the preceding claims, **characterised in that** the space-filling curve is a Hilbert curve (11; 31).

5. Electroadhesion gripper (60a; 60b) according to any one of the preceding claims, **characterised in that** the electroadhesion gripper (60) has exactly two electrodes (41, 42; 51, 52), namely the first electrode (41; 51) and the second electrode (42; 52).

6. Electroadhesion gripper (60a; 60b) according to any one of the preceding claims, **characterised in that** the first electrode (41; 51) and the second electrode (42; 52) are rounded-off at ends and/or corners of the respective border lines thereof.

7. Electroadhesion gripper (60a; 60b) according to any one of the preceding claims, **characterised in that** a smallest spacing (AB) between the first electrode (41; 51) and the second electrode (42; 52) in the plan view of the electrodes (41, 42; 51, 52) is 3.0 mm or less, preferably 1.0 mm or less, particularly preferably 0.3 mm or less.

8. Electroadhesion gripper (60a; 60b) according to any one of the preceding claims, **characterised in that** the first electrode (41; 51) and the second electrode (42; 52) have a uniform width (B) in the sub-region in the plan view of the electrodes (41, 42; 51, 52).

9. Electroadhesion gripper (60a; 60b) according to any one of the preceding claims, **characterised in that**, in the sub-region in the plan view of the electrodes (41, 42; 51, 52), the first electrode (41; 51) and/or the second electrode (42; 52) are printed onto a dielectric insulating film (61), and the film (61) is glued to a holding structure (62).

10. Electroadhesion gripper (60a; 60b) according to any one of claims 1 to 9, **characterised in that**, in the sub-region, the first electrode (41; 51) and the second electrode (42; 52) are arranged in a common plane (GE).

11. Electroadhesion gripper (60a; 60b) according to any one of claims 1 to 9, **characterised in that**, in the sub-region, the first electrode (41; 51) is arranged in a first plane (EB1) and the second electrode (42; 52) is arranged in a second plane (EB2), the first plane (EB1) and the second plane (EB2) being coplanar and mutually spaced.

12. Electroadhesion gripper (60a; 60b) according to any one of the preceding claims, **characterised in that** the enclosure is interrupted at at least two points for a division into the two electrodes, in particular the starting point and the end point of the space-filling curve not being completely enclosed.

## Revendications

1. Préhenseur à électroadhérence (60a ; 60b) destiné à maintenir des pièces ouvrées (53 ; 54 ; 64),
comprenant une première électrode (41 ; 51) et une deuxième électrode (42 ; 52) qui, en vue de dessus sur les électrodes (41, 42 ; 51, 52), sont configurées pour être imbriquées les unes dans les autres,
**caractérisé en ce que**
au moins dans une zone partielle, dans la vue de dessus sur les électrodes (41, 42 ; 51, 52), la première électrode (41 ; 51) et la deuxième électrode (42 ; 52) sont configurées conformément aux lignes de bordure d'une courbe fractale bidimensionnelle de remplissage d'espace du deuxième ordre ou d'un ordre supérieur, les lignes de bordure étant notamment obtenues par entourage bilatéral du tracé de la courbe de remplissage d'espace sur une grille auxiliaire, qui est décalée d'un demi pas de grille dans chaque direction de grille par rapport à une grille de la courbe de remplissage d'espace.

2. Préhenseur à électroadhérence (60a ; 60b) selon la revendication 1, **caractérisé en ce que** la première électrode (41 ; 51) et la deuxième électrode (42 ; 52) sont configurées conformément à une première partie (T1) et à une deuxième partie (T2) des lignes de bordure de la courbe de remplissage d'espace, la première partie (T1) et la deuxième partie (T2) des lignes de bordure étant séparées l'une de l'autre dans la zone d'un début (A) et dans la zone d'une fin (E) de la courbe de remplissage d'espace.

3. Préhenseur à électroadhérence (60a ; 60b) selon la revendication 1 ou 2, **caractérisé en ce que** la courbe de remplissage d'espace est du troisième ordre ou d'un ordre supérieur, de préférence du quatrième ordre ou d'un ordre supérieur.

4. Préhenseur à électroadhérence (60a ; 60b) selon l'une des revendications précédentes, **caractérisé en ce que** la courbe de remplissage d'espace est une courbe de Hilbert (11 ; 31).

5. Préhenseur à électroadhérence (60a ; 60b) selon l'une des revendications précédentes, **caractérisé en ce que** le préhenseur à électroadhérence (60) possède exactement deux électrodes (41, 42 ; 51, 52), à savoir la première électrode (41 ; 51) et la deuxième électrode (42 ; 52).

6. Préhenseur à électroadhérence (60a ; 60b) selon l'une des revendications précédentes, **caractérisé en ce que** la première électrode (41 ; 51) et la deuxième électrode (42 ; 52) sont de configuration arrondie aux extrémités et/ou aux coins de leurs lignes de bordure respectives.

7. Préhenseur à électroadhérence (60a ; 60b) selon l'une des revendications précédentes, **caractérisé en ce qu'**un plus petit écart (AB) entre la première électrode (41 ; 51) et la deuxième électrode (42 ; 52), en vue de dessus sur les électrodes (41, 42 ; 51, 52), est inférieur ou égal à 3,0 mm, de préférence inférieur ou égal à 1,0 mm, notamment de préférence inférieur ou égal à 0,3 mm.

8. Préhenseur à électroadhérence (60a ; 60b) selon l'une des revendications précédentes, **caractérisé en ce que** dans la zone partielle dans la vue de dessus sur les électrodes (41, 42 ; 51, 52), la première électrode (41 ; 51) et la deuxième électrode (42 ; 52) sont configurées avec une largeur (B) uniforme.

9. Préhenseur à électroadhérence (60a ; 60b) selon l'une des revendications précédentes, **caractérisé en ce que** dans la zone partielle dans la vue de dessus sur les électrodes (41, 42 ; 51, 52), la première électrode (41 ; 51) et/ou la deuxième électrode (42 ; 52) sont imprimées sur un film (61) diélectrique isolant et le film (61) est collé sur une structure de maintien (62).

10. Préhenseur à électroadhérence (60a ; 60b) selon l'une des revendications 1 à 9, **caractérisé en ce que** dans la zone partielle, la première électrode (41 ; 51) et la deuxième électrode (42 ; 52) sont disposées dans un plan commun (GE).

11. Préhenseur à électroadhérence (60a ; 60b) selon l'une des revendications 1 à 9, **caractérisé en ce que** dans la zone partielle, la première électrode (41 ; 51) est disposée dans un premier plan (EB1) et la deuxième électrode (42 ; 52) dans un deuxième plan (EB2), le premier plan (EB1) et le deuxième plan (EB2) étant disposés de manière coplanaire et espacés l'un de l'autre.

12. Préhenseur à électroadhérence (60a ; 60b) selon l'une des revendications précédentes, **caractérisé en ce que** l'entourage est interrompu pour un partage sur les deux électrodes en au moins deux endroits, le début et la fin de la courbe de remplissage d'espace n'étant notamment pas entièrement entourés.
